(19) Europäisches Patentamt
European Patent Office
Office européen des brevets

(11) **EP 1 275 160 B1**

(12) **EUROPÄISCHE PATENTSCHRIFT**

(45) Veröffentlichungstag und Bekanntmachung des Hinweises auf die Patenterteilung:
**24.10.2007 Patentblatt 2007/43**

(21) Anmeldenummer: **01913697.7**

(22) Anmeldetag: **21.02.2001**

(51) Int Cl.:
*H01L 41/047* (2006.01)    *H01L 41/083* (2006.01)

(86) Internationale Anmeldenummer:
**PCT/DE2001/000651**

(87) Internationale Veröffentlichungsnummer:
**WO 2001/078158 (18.10.2001 Gazette 2001/42)**

(54) **PIEZOELEKTRISCHER VIELSCHICHTAKTOR**

PIEZOELECTRIC MULTILAYERED ACTUATOR

ACTIONNEUR MULTICOUCHE PIEZO-ELECTRIQUE

(84) Benannte Vertragsstaaten:
**DE ES FR GB IT**

(30) Priorität: **11.04.2000 DE 10017975**

(43) Veröffentlichungstag der Anmeldung:
**15.01.2003 Patentblatt 2003/03**

(73) Patentinhaber: **ROBERT BOSCH GMBH**
**70442 Stuttgart (DE)**

(72) Erfinder:
• **HEINZ, Rudolf**
**71272 Renningen (DE)**
• **SUGG, Bertram**
**70839 Gerlingen (DE)**

(56) Entgegenhaltungen:
**WO-A-00/79607**          **WO-A-00/79608**
**DE-A- 19 648 545**

EP 1 275 160 B1

**Beschreibung**

Die Erfindung betrifft einen Vielschichtaktor mit einem Stapel dünner Isolierschichten aus einem piezoaktiven Material nach der Gattung des Hauptspruches.

Stand der Technik

Bekannte piezoelektrische Vielschichtaktoren, wie sie beispielsweise in Common-Rail-Dieselinjektoren bzw. in der Benzin-Direkteinspritztechnik eingesetzt werden, zeigen je nach Geometrie der eingesetzten Innenelektroden teilweise Delaminationsstellen im Bereich inaktiver Zonen des Vielschichtaktors, d. h. insbesondere im Randbereich, was schließlich zu Rissen in den außen angebrachten Außenelektroden führen kann. Diese Risse führen zu einer Unterbrechung der Stromzufuhr zu Teilen des Vielschichtaktors, so dass einzelne Isolierschichten mit piezoaktivem Material oder Gruppen von solchen Isolierschichten von der außen anliegenden Spannungsversorgung getrennt und damit inaktiv sind.

Ein monolithischer Vielschichtaktor, wie er auch Ausgangspunkt für die vorliegende Erfindung war, ist beispielsweise aus DE 196 48 545 A1 bekannt, wobei auch bereits das Problem der Delamination und der Ausbildung von Rissen in dem Piezoaktor diskutiert wird.

Zur Vermeidung dieser Delaminationen bzw. der Ausbildung von Rissen wird dort vorgeschlagen, die Seitenfläche des Piezoaktors mit einer Grundmetallisierung zu versehen und auf dieser Grundmetallisierung dann eine dreidimensional strukturierte, elektrisch leitende Elektrode anzuordnen, die mit der Grundmetallisierung über Kontaktstellen oder Lötstellen verbunden und gleichzeitig zwischen den einzelnen Kontaktstellen dehnbar ausgebildet ist. Darüber hinaus wird dort bereits vorgeschlagen, diese dreidimensional strukturierte Elektrode in Form eines Drahtgewirkes bzw. eines Drahtgeflechtes auszubilden, das eine wellenförmige oder fischgrätenförmige Strukturierung aufweist.

Durch die vorgeschlagene dreidimensional strukturierte Ausbildung der Elektrode soll erreicht werden, dass die bei Betrieb des Vielschichtaktors insbesondere in den Randbereichen entstehenden Dehnkräfte durch die Struktur der Außenelektrode kompensiert werden, so dass die Lötstellen bzw. Kontaktstellen möglichst wenig beansprucht werden und nicht abreißen.

Aufgabe der vorliegenden Erfindung war, eine zu der in DE 196 48 545 A1 vorgeschlagenen Lösung alternative Ausführungsform bereitzustellen, wobei durch eine spezielle Ausbildung der Außenelektrode auf eine dreidimensionale Strukturierung insbesondere auch verzichtet werden kann. Darüber hinaus sollen durch die Struktur der Außenelektrode in den Außenelektroden auftretende Kräfte, die durch eine Längskontraktion bzw. Längsdilatation und eine dadurch ebenfalls hervorgerufene Querdehnung bzw. Querstauchung verursacht werden, kompensiert werden.

Aus der nicht vorveröffentlichten WO 00/79607 A1 ist bereits ein Piezoaktor bekannt, der einen Mehrschichtaufbau von Piezolagen und dazwischen angeordneten Innenelektroden aufweist, wobei eine wechselseitige seitliche Kontaktierung der Innenelektroden über Außenelektroden, über die eine elektrische Spannung zuführbar ist, erfolgt. Eine Außenelektrode ist netz- oder gewebeartig auf jeweils einer Seitenfläche verteilt aufgebracht und zumindest punktweise mit den jeweiligen Innenelektroden kontaktiert. Zwischen den Kontaktierungen kommt ein dehnbarer Bereich zu liegen. Als eine erste Außenelektrode ist eine leitende Fläche auf jeweils einer Seitenfläche angebracht, die mit den jeweiligen Innenelektroden kontaktiert ist, und die zweite netz- oder gewebeartige Außenelektrode ist auf der ersten Außenelektrode angeordnet. Die Zuführung der elektrischen Spannung erfolgt über Anschlüsse, die ebenfalls zwischen den Bereichen der Kontaktfläche oder -punkte dehnbare Bereiche aufweisen und die an elastischen Falzbereichen liegen.

Vorteile der Erfindung

Der erfindungsgemäße Vielschichtaktor hat gegenüber dem Stand der Technik den Vorteil, dass bei Betrieb des Vielschichtaktors im Bereich der Außenelektroden auftretende Kräfte, d. h. sowohl Längskräfte als auch Querkräfte, zumindest weitgehend ausgeglichen werden können, so dass bei Betrieb im Wesentlichen keine Kräfte auf den als Geflecht ausgebildeten Teil der Außenelektrode übertragen werden. Somit werden die Lötstellen oder Kontaktstellen deutlich entlastet und ausfallsicher. Insbesondere ist es nun auch nicht mehr erforderlich, dass das als Teil der Außenelektroden ausgebildete Geflecht die Dehnungen bzw. Dilatationen des Aktors zu einem großen Teil mit macht. Insgesamt wird somit einerseits eine Delamination der Außenelektroden und eine Rissbildung in den Vielschichtaktor vermieden, und andererseits werden die erzeugten Lötstellen deutlich entlastet.

Darüber hinaus hat der erfindungsgemäße Vielschichtaktor den Vorteil, dass auch bei einem unvorhergesehenen Abreißen einer Lötstelle stets ausreichend viele stromführende Pfade als Überbrückungsmöglichkeiten dieser abgerissenen Lötstelle zur Verfügung stehen, so dass das Auftreten von inaktiven Isolationsschichten weitgehend vermieden werden kann.

Dadurch dass die Außenelektroden ein Geflecht aufweisen, das eine siebähnliche Struktur hat, lässt sich zudem nun auch der Lötprozess, d. h. das stellenweise Verlöten des aufgebrachten Geflechtes mit der darunter befindlichen, in unmittelbarem Kontakt mit den Innenelektroden stehenden Leitschicht einerseits und das stellenweise Verlöten des aufgebrachten Geflechtes mit mit einer äußeren Spannungsversorgung in Verbindung stehenden Anschlußkontakten andererseits, effektiv und zuverlässig ausführen und kontrollieren.

Schließlich ist es durch die Struktur des Geflechtes nun auch in einfacher Weise möglich, beim Löten eingesetzte Flussmittel bzw. verbliebene Flussmittelreste auszuwaschen.

Ganz besonders vorteilhaft ist, wenn die Schussfäden und die Kettfäden des aufgebrachten Geflechtes derart miteinander verwoben bzw. verflochten sind, dass die sich einstellenden Zwischenräume, d. h. die Maschen, zumindest näherungsweise die Form einer Raute aufweisen.

Eine besonders vorteilhafter Aspekt der Erfindung besteht darin, den Innenwinkel dieser Raute über die bei Betrieb auftretende relative Längenänderung bzw. die relative Querkontraktion des Vielschichtaktors zu definieren. Durch eine definierte Einstellung dieses Winkels auf einen vorgegebenen Wert kann eine zumindest nahezu vollständige Aufhebung der Längs- und Querkräfte in dem Geflecht erreicht werden. Dabei ist weiterhin vorteilhaft, dass sich dieser Innenwinkel der Raute unabhängig von der konkreten relativen Längenänderung bzw. relativen Querkontraktion des Vielschichtaktors über die piezoelektrischen Koeffizienten des piezoaktiven Materials der Isolierschichten in eindeutiger Weise festlegen lässt.

Somit kann durch die Ausbildung des als Teil der Außenelektroden aufgebrachten Geflechtes in Form eines Siebes mit rautenförmigen Maschen mit definiertem Innenwinkel eine mechanische Belastung dieses Geflechtes nahezu vollständig vermieden werden. Durch die rautenförmige Ausbildung der Maschen des Siebes und das definierte Auflöten dieses Siebes auf die auf der Seitenfläche des Vielschichtaktors aufgebrachte Leitschicht tritt insbesondere auch keine Dehnung in den Drähten des Siebes bzw. Geflechtes auf. Das Auflöten erfolgt im Übrigen bevorzugt derart, dass der genannte Innenwinkel quer zur Richtung der Längsdilatation oder Längskontraktion ausgerichtet ist.

Vorteilhafte Weiterbildungen der Erfindungen ergeben sich aus den in den Unteransprüchen genannten Maßnahmen.

So kann es vorteilhaft sein, wenn das Geflecht in Form eines Siebes ausgeführt und gleichzeitig die Schuss- und Kettfäden dieses Geflechtes bzw. Siebes eng aufeinander liegen. In diesem Fall wird eine elastische Deformation der Schuss- bzw. Kettfäden bei einer Dehnung des Vielschichtaktors eingeschränkt.

Weiterhin ist vorteilhaft, dass das beim Verlöten eingesetzte Lot nur teilweise in die Schnittstellen (Lötstellen) zwischen Schuss- und Kettfäden einfließen und dort zusätzlich die Dehnung bzw. die elastische Deformation des Geflechtes behindern kann.

Die Raute ist dabei bevorzugt derart orientiert, dass eine der Diagonalen dieser Raute parallel zu einer beim Betrieb des Stapels auftretenden Längskontraktion oder Längsdilatation ausgerichtet ist.

Das aufgebrachte Geflecht kann vorteilhaft vor dem Verlöten einerseits durch Recken in die richtige Rautenform gebracht werden oder andererseits bereits so gewebt bzw. hergestellt werden.

Insgesamt hat der erfindungsgemäße Vielschichtaktor mit dem als Teil der Außenelektrode ausgebildeten Geflecht den Vorteil einer einfachen Herstellung und deutlich verringerter Ausfallraten.

Zeichnungen

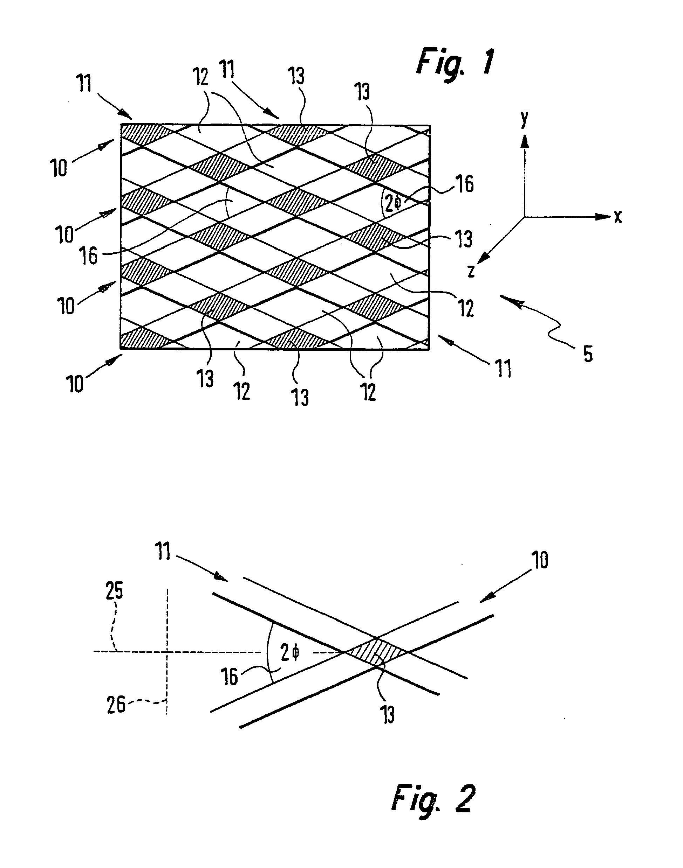

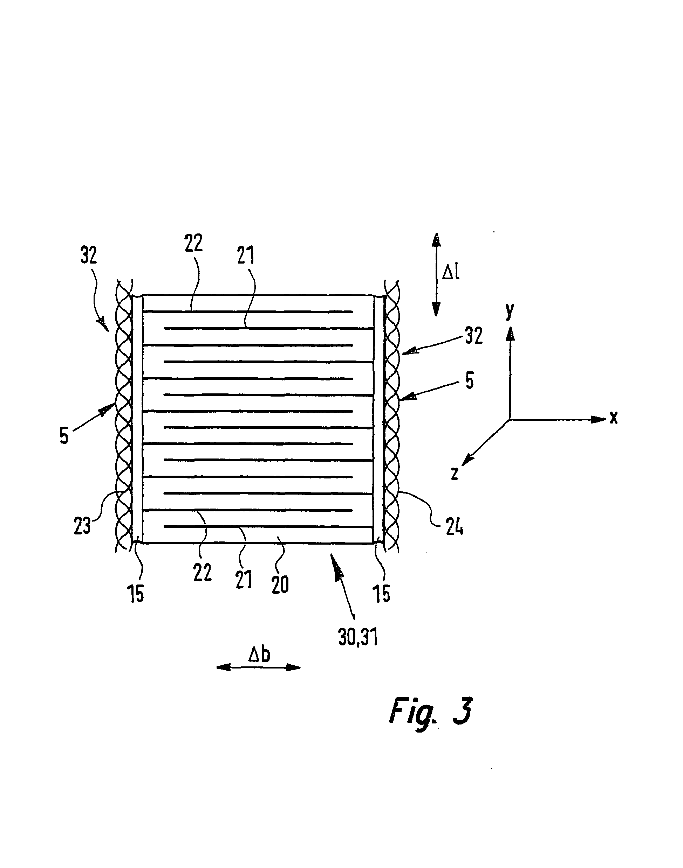

Die Erfindung wird anhand der Zeichnungen und in der nachfolgenden Beschreibung näher erläutert. Es zeigt Figur 1 ein Geflecht in Form eines Siebes mit rautenförmigen Maschen, Figur 2 eine Ausschnittvergrößerung aus Figur 1, und Figur 3 einen Vielschichtaktor mit einem Geflecht gemäß Figur 1 als Teil der Außenelektroden.

Ausführungsbeispiele

Die Figur 3 zeigt zunächst einen Schnitt durch einen an sich bekannten Vielschichtaktor 30 in Form eines Stapels 31 piezoaktiver, insbesondere keramischer Isolierschichten 20 mit dazwischen eingelagerten, metallischen Innenelektroden 21, 22. Die Innenelektroden 21, 22 sind wechselseitig aus dem Stapel 31 herausgeführt und über zugeordnete Außenelektroden 23, 24 elektrisch parallel geschaltet. Zur Parallelschaltung der Innenelektroden 21, 22 ist auf den Kontaktseiten des Stapels 31 eine Grundmetallisierung in Form einer Leitschicht 15 aufgebracht, insbesondere aufgelötet, die eine typische Dicke von 2 Mikrometer bis 60 Mikrometer aufweist. Alternativ zum Auflöten kann die Leitschicht 15 auch durch Siebdruck oder galvanisch aufgebracht sein.

Darüber hinaus ist in Figur 3 dargestellt, dass die auf den Kontaktflächen bzw. Seitenflächen des Stapels 31 aufgebrachte Leitschicht 15 jeweils mit einem Geflecht 5 über Lötstellen 13 in Verbindung steht, was im Folgenden noch im Detail erläutert wird.

In Figur 3 ist weiter angedeutet, dass bei Betrieb des Vielschichtpiezoaktors 30 eine Längenänderung $\Delta l$ in Längsrichtung auftritt. Diese Längenänderung kann je nach von außen angelegter Spannung eine Längskontraktion oder eine Längsdilatation sein. Die Längsrichtung ist in Figur 3 im übrigen durch die y-Richtung gekennzeichnet. Durch die Längenänderung in y-Richtung tritt zwangsläufig auch eine Querkontraktion oder Querdilatation $\Delta b$ in x-Richtung und z-Richtung auf. Weitere Details zu dem, abgesehen von der Struktur des Geflechtes 5, bekannten Vielschichtaktor 30 können der DE 196 48 545 A1 entnommen werden. Darüber hinaus sind derartige monolithische Vielschichtaktoren auch in DE 40 36 287 C2 beschrieben.

Die Figur 1 erläutert im Einzelnen die Struktur des Geflechtes 5 gemäß Figur 3, das stellenweise auf die Leitschicht 15 aufgelötet ist. Das Geflecht 5 besteht dabei aus zumindest weitgehend parallel zueinander verlaufenden Schussfäden 10 und zumindest weitgehend parallel zueinander verlaufenden Kettfäden 11, die in ihren Schnittstellen 13 miteinander verbunden, insbesondere miteinander verlötet sind. Die Schussfäden 10 und die Kettfäden 11 sind im erläuterten Beispiel aus elektrisch leitfähigen Fäden, insbesondere metallischem Draht, gefertigt, der bevorzugt einen Durchmesser von 10 Mikrometer bis 250 Mikrometer, insbesondere 50 Mikrometer bis 150 Mikrometer, aufweist.

Das Geflecht 5 hat somit die Form eines Siebes, wobei die Schnittstellen 13 von Schussfäden 10 und Kettfäden 11 miteinander verbunden sind. Weiterhin sind die Schussfäden 10 und die Kettfäden 11 in dem Geflecht 5 derart miteinander verwoben bzw. verflochten, dass sich die einstellenden Zwischenräume 12, d. h. die sich bildenden Maschen, zumindest näherungsweise die Form einer Raute aufweisen. Das Geflecht 5 ist dabei derart orientiert bzw. derart auf die Leitschicht 15 aufgebracht, dass eine erste Diagonale 26 der rautenförmigen Zwischenräume 12 parallel zu der beim Betrieb des Stapels 31 auftretenden Längskontraktion bzw. Längsdilatation ausgerichtet ist. Die erste Diagonale 26 ist somit parallel der y-Richtung orientiert, während die zweite Diagonale der rautenförmigen Zwischenräume 12 parallel zu der x-Richtung oder der z-Richtung orientiert ist.

Die Maschenweite der Zwischenräume 12, d. h. die Abstände der Schussfäden 10 voneinander bzw. der Kettfäden 11 voneinander beträgt typischerweise 30 Mikrometer bis 400 Mikrometer, insbesondere 100 Mikrometer bis 200 Mikrometer.

Das Geflecht 5 ist im Übrigen bevorzugt an allen Schnittstellen 13 von Schussfäden 10 und Kettfäden 11 mit der Leitschicht 15 verlötet.

Um sicherzustellen, dass bei einer Längskontraktion bzw. Längsdilatation des Piezoaktors 30 das Geflecht 5 möglichst kräftefrei ist, so dass auf die Lötstellen bzw. Schnittstellen 13 möglichst keine Kräfte einwirken, unterliegen die rautenförmigen Zwischenräume 12 bevorzugt einer einschränkenden Bedingung hinsichtlich des Innenwinkels der Zwischenräume 12. Dies wird mit Hilfe der Figur 2 näher erläutert.

Im Einzelnen zeigt Figur 2 einen Ausschnitt aus Figur 1 im Bereich einer Schnittstelle 13 wobei lediglich ein Teil eines rautenförmigen Zwischenraumes 12 dargestellt ist. Weiter sind in Figur 2 die erste Rautendiagonale 25 und die zweite Rautendiagonale 26 dieses rautenförmigen Zwischenraumes 12 eingetragen. Die zweite Rautendiagonale 26 ist dabei parallel zur y-Richtung gemäß Figur 1 bzw. Figur 3 orientiert. Weiter ist in Figur 2 dargestellt, dass die Kettfäden 11 und die Schussfäden 10 einen ersten Innenwinkel 16 einschließen, der im folgenden mit 2φ bezeichnet ist. Der erste Innenwinkel 16 ist im erläuterten Beispiel gemäß Figur 2 derjenige Innenwinkel des rautenförmigen Zwischenraumes 12, der von der zweiten Rautendiagonale 25, d. h. der parallel zu der x-Richtung verlaufenden Rautendiagonale, halbiert wird.

Der erste Innenwinkel 16 (2φ) wird nun derart dimensioniert, d. h. die Schussfäden 10 und die Kettfäden 11 werden derart miteinander verwoben bzw. nach dem Weben derart gereckt, dass er einerseits quer zur Längsdehnungsrichtung orientiert ist, und andererseits so an die Querdehnung/Querkontraktion und die Längsdehnung/Längskontraktion angepasst ist, dass in den Schussfäden 10 und in den Kettfäden 11 zumindest näherungsweise keine Dehnung auftritt.

An dieser Stelle sei betont, dass bei üblichen Piezoaktoren 30 die relative Längenänderung des Stapels 31, d. h. $\Delta l/l$ wobei l die Höhe des Stapels 31 bezeichnet, zwischen 0,1 % bis 0,15 % liegt. Entsprechend liegen die üblichen relativen Querkontraktionen bzw. Querdilatationen $\Delta b/b$ des Stapels 31, die durch die induzierte Längenänderung $\Delta l$ hervorgerufen werden, bei etwa der Hälfte der relativen Längenänderung des Stapels 31. Unter der Größe b ist dabei die Seitenlänge einer Seitenfläche des Piezoaktors 30 zu verstehen. Im erläuterten Beispiel hat der Stapel 31 bei Draufsicht in Längsrichtung eine quadratische Grundfläche. Es ist jedoch ebenso möglich, den Stapel 31 mit rechteckiger, sechseckiger oder achteckiger Grundfläche auszubilden.

Ein quaderförmiger Piezoaktor 30 der Länge l dehnt sich somit beispielsweise bei Anlegen eines elektrischen Feldes E an die Isolierschichten 20 um $\Delta l$ in Feldrichtung, während er gleichzeitig in den dazu orthogonalen Richtungen kontrahiert wird. Die Breite b reduziert sich dabei um $\Delta b$. Die Verhältnisse $\varepsilon = \Delta l/l$ und $\delta = \Delta b/b$ werden als Längsdehnung bzw. Querkontraktion bezeichnet.

Aus der Forderung, dass bei dem aufgelöteten rautenförmigen Geflecht 5 die Seitenlängen der Rauten konstant bleiben soll, d. h. dass der rautenförmige Zwischenraum 12 weder elastisch noch plastisch verformt wird, leitet sich für den ersten Innenwinkel 16 leicht folgender Zusammenhang her:

$$\tan(\phi) = \sqrt{\frac{2\delta - \delta^2}{2\varepsilon + \varepsilon^2}}$$

Da in allen Fällen die relative Längenänderung $\Delta l/l$ bzw. die relative Querkontraktion $\Delta b/b$ stets erheblich kleiner 1 ist, kann diese Formel in allen für die Praxis relevanten Fällen angenähert werden durch die Formel:

$$\tan(\phi) \approx \sqrt{\frac{\delta}{\varepsilon}}$$

Da weiter gilt $\delta = d_{31} \cdot E$ und $\varepsilon = d_{33} \cdot E$, folgt für den Winkel φ schließlich:

$$\tan(\phi) \approx \sqrt{\frac{d_{31}}{d_{33}}}$$

Aus vorstehender Formel ergibt sich insbesondere, dass der erste Innenwinkel 16 ($2\phi$) nicht von der angelegten Feldstärke E sondern nur von den den einzelnen Richtungen zugeordneten piezoelektrischen Koeffizienten $d_{31}$ und $d_{33}$ des Materials der Isolierschichten 20 abhängig ist, die beispielsweise aus einem piezoaktiven keramischen Material bestehen.

**Patentansprüche**

1. Vielschichtaktor mit einem Stapel (31) dünner Isolierschichten (20) aus einem piezoaktiven Material mit eingelagerten, wechselseitig aus dem Stapel (31) herausführenden Innenelektroden (21, 22), die über eine der jeweiligen Seite des Stapels (31) zugeordneten Außenelektrode (23, 24) elektrisch parallel geschaltet sind wobei mindestens eine der Außenelektroden (23, 24) eine Leitschicht (15) und ein mit der Leitschicht (15) stellenweise verbundenes Geflecht (5) aufweist, wobei das Geflecht (5) jeweils zumindest weitgehend parallel zueinander verlaufende Schussfäden (10) und jeweils zumindest weitgehend parallel zueinander verlaufende Kettfäden (11) aufweist, die an ihren Schnittstellen (13) miteinander verbunden, insbesondere verlötet, sind, **dadurch gekennzeichnet,** **dass** die Schussfäden (10) und die Kettfäden (11) des Geflechtes (5) derart miteinander verwoben oder verflochten sind, dass die sich einstellenden Zwischenräume zumindest näherungsweise die Form einer Raute aufweisen und sich als erster Innenwinkel (16) der rautenförmigen Zwischenräume (12), der $2\phi$ beträgt, ein Winkel ergibt, für den zumindest näherungsweise gilt:

$$\tan(\phi) \approx \sqrt{\frac{\delta}{\varepsilon}}$$

mit $\delta = \dfrac{\Delta b}{b}$ und $\varepsilon = \dfrac{\Delta l}{l}$

wobei $\Delta l/l$ die relative Längenänderung des Stapels (31) der Länge 1 bei einer Längskontraktion oder Längsdilatation und $\Delta b/b$ die relative Querkontraktion oder Querdilatation des Stapels (31) der Seitenbreite b durch die Längenänderung $\Delta l$ bezeichnet, so dass bei Betrieb des Vielschichtaktors im Bereich der Außenelektrode (23, 24) auftretende Kräfte aufgrund einer Längskontraktion oder einer Längsdilatation des Stapels (31) innerhalb des Geflechtes (5) zumindest weitgehend ausgeglichen werden.

2. Vielschichtaktor mit einem Stapel (31) dünner Isolierschichten (20) aus einem piezoaktiven Material mit eingelagerten, wechselseitig aus dem Stapel (31) herausführenden Innenelektroden (21, 22), die über eine der jeweiligen Seite des Stapels (31) zugeordneten Außenelektrode (23, 24) elektrisch parallel geschaltet sind, wobei mindestens eine der Außenelektroden (23, 24) eine Leitschicht (15) und ein mit der Leitschicht (15) stellenweise verbundenes Geflecht (5) aufweist, wobei das Geflecht (5) jeweils zumindest weitgehend parallel zueinander verlaufende Schussfäden (10) und jeweils zumindest weitgehend parallel zueinander verlaufende Kettfäden (11) aufweist, die an ihren Schnittstellen (13) miteinander verbunden, insbesondere verlötet, sind, **dadurch gekennzeichnet,** **dass** die Schussfäden (10) und die Kettfäden (11) des Geflechtes (5) derart miteinander verwoben oder verflochten sind, dass die sich einstellenden Zwischenräume zumindest näherungsweise die Form einer Raute aufweisen und sich als erster Innenwinkel (16) der rautenförmigen Zwischenräume (12), der $2\phi$ beträgt, ein Winkel ergibt, für den zumindest näherungsweise gilt:

$$\tan(\phi) \approx \sqrt{\frac{d_{31}}{d_{33}}}$$

wobei $d_{31}$ und $d_{33}$ die der Längenänderung $\Delta l$ bzw. der dadurch induzierten Querkontraktion $\Delta b$ entsprechenden piezoelektrischen Koeffizienten des piezoaktiven Materials der Isolierschichten (20) bezeichnen, so dass bei Betrieb des Vielschichtaktors im Bereich der Außenelektrode (23, 24) auftretende Kräfte aufgrund einer Längskontraktion oder einer Längsdilatation des Stapels (31) innerhalb des Geflechtes (5) zumindest weitgehend ausgeglichen werden.

3. Vielschichtaktor nach Anspruch 1 oder 2, **dadurch gekennzeichnet,** **dass** die Schussfäden (10) und die Kettfäden (11) derart miteinander verwoben oder verflochten sind und dass das Geflecht (5) derart stellenweise mit der Leitschicht (15) verbunden ist, dass eine erste Diagonale (26) der rautenförmigen Zwischenräume (12) parallel zu der beim Betrieb des Stapels (31) auftretenden Längskontraktion oder Längsdilatation ausgerichtet ist.

4. Vielschichtaktor nach mindestens einem der vorangehenden Ansprüche,
**dadurch gekennzeichnet,**
**dass** das Geflecht (5) aus elektrisch leitfähigen Fäden (10, 11), insbesondere metallischem Draht, besteht.

**5.** Vielschichtaktor nach mindestens einem der vorangehenden Ansprüche,
**dadurch gekennzeichnet,**
**dass** die Leitschicht (15) eine metallische Lotschicht, eine aufgedruckte Schicht oder eine galvanisch abgeschiedene Schicht, insbesondere mit einer Dicke von 2 μm bis 60 μm, ist.

**6.** Vielschichtaktor nach mindestens einem der vorangehenden Ansprüche,
**dadurch gekennzeichnet,**
**dass** der Stapel (31) bei Draufsicht in Längsrichtung eine rechteckige, quadratische, sechseckige oder achteckige Grundfläche aufweist.

**7.** Vielschichtaktor nach mindestens einem der vorangehenden Ansprüche,
**dadurch gekennzeichnet,**
**dass** die Fäden (10, 11) oder der Draht einen Durchmesser von 10 μm bis 250 μm, insbesondere 50 μm bis 150 μm, aufweisen.

**Claims**

**1.** Multilayered actuator comprising a stack (31) of thin insulating layers (20) made of a piezoactive material with incorporated internal electrodes (21, 22), which are alternately led out from the stack (31) and are connected electrically in parallel via an external electrode (23, 24) assigned to the respective side of the stack (31), at least one of the external electrodes (23, 24) having a conducting layer (15) and an interwoven structure (5) connected at certain places to the conducting layer (15), the interwoven structure (5) comprising weft threads (10), respectively running at least largely parallel to one another, and warp threads (11), respectively running at least largely parallel to one another, which threads are connected, in particular soldered, to one another at their points of intersection (13), **characterized in that** the weft threads (10) and the warp threads (11) of the interwoven structure (5) are interwoven with one another in such a way that the interspaces produced have at least approximately the form of a lozenge and, obtained as the first interior angle (16) of the lozenge-shaped interspaces (12), which is 2φ, is an angle for which the following at least approximately applies:

$$\tan(\phi) \approx \sqrt{\frac{\delta}{\varepsilon}}$$

with $\delta = \frac{\Delta b}{b}$ and $\varepsilon = \frac{\Delta l}{l}$

where Δl/l denotes the relative change in length of the stack (31) of the length 1 when there is a longitudinal contraction or longitudinal dilation and Δb/b denotes the relative transverse contraction or transverse dilation of the stack (31) of the side width b that is brought about by the change in length Δl, so that, during the operation of the multilayered actuator, forces occurring in the region of the external electrode (23, 24) on account of a longitudinal contraction or a longitudinal dilation of the stack (31) are at least largely compensated within the interwoven structure (5).

**2.** Multilayered actuator comprising a stack (31) of thin insulating layers (20) made of a piezoactive material with incorporated internal electrodes (21, 22), which are alternately led out from the stack (31) and are connected electrically in parallel via an external electrode (23, 24) assigned to the respective side of the stack (31), at least one of the external electrodes (23, 24) having a conducting layer (15) and an interwoven structure (5) connected at certain places to the conducting layer (15), the interwoven structure (5) comprising weft threads (10), respectively running at least largely parallel to one another, and warp threads (11), respectively running at least largely parallel to one another, which threads are connected, in particular soldered, to one another at their points of intersection (13), **characterized in that** the weft threads (10) and the warp threads (11) of the interwoven structure (5) are interwoven with one another in such a way that the interspaces produced have at least approximately the form of a lozenge and, obtained as the first interior angle (16) of the lozenge-shaped interspaces (12), which is 2φ, is an angle for which the following at least approximately applies:

$$\tan(\phi) \approx \sqrt{\frac{d_{31}}{d_{33}}}$$

where $d_{31}$ and $d_{33}$ denote the piezoelectric coefficients of the piezoelectric material of the insulation layers (20) that correspond to the change in length Δl or the transverse contraction Δb thereby induced,

so that, during the operation of the multilayered actuator, forces occurring in the region of the external electrode (23, 24) on account of a longitudinal contraction or a longitudinal dilation of the stack (31) are at least largely compensated within the interwoven structure (5).

3. Multilayered actuator according to Claim 1 or 2, **characterized in that** the weft threads (10) and the warp threads (11) are interwoven with one another in such a way and the interwoven structure (5) is connected to the conducting layer (15) at certain places in such a way that a first diagonal (26) of the lozenge-shaped interspaces (12) is aligned parallel to the longitudinal contraction or longitudinal dilation occurring during the operation of the stack (31).

4. Multilayered actuator according to at least one of the preceding claims, **characterized in that** the interwoven structure (5) comprises electrically conductive threads (10, 11), in particular metal wire.

5. Multilayered actuator according to at least one of the preceding claims, **characterized in that** the conducting layer (15) is a metal solder layer, a printed-on layer or an electrodeposited layer, in particular with a thickness of 2 $\mu$m to 60 $\mu$m.

6. Multilayered actuator according to at least one of the preceding claims, **characterized in that**, in plan view, the stack (31) has in the longitudinal direction a rectangular, square, hexagonal or octagonal base area.

7. Multilayered actuator according to at least one of the preceding claims, **characterized in that** the threads (10, 11) or the wire have/has a diameter of 10 $\mu$m to 250 $\mu$m, in particular 50 $\mu$m to 150 $\mu$m.

**Revendications**

1. Actionneur multicouches comportant une pile (31) de couche isolantes minces (20) en une matière piezoactive et interposition d'électrodes internes (21, 22) sortant par les côtés opposés de la pile (31) et branchées électriquement en parallèle sur chaque côté respectif de la pile (31), en étant associées à des électrodes externes (23, 24),
au moins l'une des électrodes externes (23, 24) a une couche conductrice (15) et un tissu (5) relié par endroit à la couche conductrice (15),
le tissu (5) ayant au moins des fils de trame (10) pratiquement parallèles et chaque fois au moins des fils de chaîne (11) pratiquement parallèles, sont reliés aux intersections (13) notamment par soudage,
**caractérisé en ce que**
les fils de trame (10) et les fils de chaîne (11) du tissu (5) sont tissés ou tressés pour que les intervalles qui se forment ont au moins approximativement la forme d'un losange et le premier angle interne (16) des intervalles (12) en forme de losange est égal à 2$\phi$ qui est un angle répondant au moins approximativement aux formules suivantes :

$$\tan(\phi) \approx \sqrt{\frac{\delta}{\varepsilon}}$$

avec $\delta = \dfrac{\Delta b}{b}$  et  $\varepsilon = \dfrac{\Delta \ell}{\ell}$

relation dans laquelle :

- $\Delta l/l$ est la variation relative de longueur de la pile (31) ayant pour longueur 1 pour une contraction longitudinale ou une dilatation longitudinale,
- $\Delta b/b$ est la contraction transversale relative ou dilatation transversale relative de la pile (31) pour la largeur b et la variation de longueur $\Delta l$,

de sorte que
les efforts engendrés par une contraction longitudinale ou une dilatation longitudinale de la pile (31) dans le tissu (5) sont pratiquement compensés en fonctionnement de l'actionneur multicouches, au niveau de l'électrode extérieure (23, 24).

2. Actionneur multicouches comportant une pile (31) de couche isolantes minces (20) en une matière piezoactive et interposition d'électrodes internes (21, 22) sortant par les côtés opposés de la pile (31) et branchées électriquement en parallèle sur chaque côté respectif de la pile (31), en étant associées à des électrodes externes (23, 24), au moins l'une des électrodes externes (23, 24) a une couche conductrice (15) et un tissu (5) relié par endroit à la couche conductrice (15),
le tissu (5) ayant au moins des fils de trame (10) pratiquement parallèles et chaque fois au moins des fils de chaîne (11) pratiquement parallèles, sont reliés aux intersections (13) notamment par soudage,
**caractérisé en ce que**
les fils de trame (10) et les fils de chaîne (1) du tissu (5) sont tissés ou tressés pour que les intervalles qui se forment, ont au moins sensiblement la forme d'un losange dont le premier angle intérieur (16) des volumes intermédiaires (12) en forme de losange est égal à 2$\phi$, qui donnent un angle répondant au moins sensiblement à la formule suivante :

$$\tan(\phi) \approx \sqrt{\frac{d_{31}}{d_{33}}}$$

dans laquelle $d_{31}$ et $d_{33}$ sont les coefficients piézo-électriques de la matière piézo-électrique des couches isolantes (20) qui correspondent à la variation de longueur $\Delta l$ ou à la contraction transversale $\Delta b$ qui est induite,
de sorte que pendant le fonctionnement de l'actionneur multicouches, les efforts engendrés au niveau des électrodes extérieures (23, 24) par la contraction ou la dilatation longitudinale de la pile (31) soient au moins compensés dans une très large mesure dans le tissu (5).

3. Actionneur multicouches selon la revendication 1 ou 2,
**caractérisé en ce que**
les fils de trame (10) et les fils de chaîne (11) sont tissés ou tressés les uns avec les autres et le tissu (5) est relié par endroit à la couche conductrice (15) de façon qu'une première diagonale (26) des intervalles en forme de losange (12) soit alignée parallèlement aux contractions longitudinales ou dilatations longitudinales qui se produisent pendant le fonctionnement de la pile (31).

4. Actionneur multicouches selon l'une des revendications précédentes,
**caractérisé en ce que**
le tissu (5) est formé de fils (10, 11) électro-conducteurs notamment de fils métalliques.

5. Actionneur multicouches selon l'une quelconque des revendications précédentes,
**caractérisé en ce que**
la couche conductrice (15) est une couche de brasure métallique, une couche imprimée ou une couche de dépôt galvanique, notamment d'une épaisseur de 2 $\mu$m jusqu'à 60 $\mu$m.

6. Actionneur multicouches selon l'une quelconque des revendications précédentes,
**caractérisé en ce que**
la pile (31) présente en vue de dessus, dans la direction longitudinale, une surface de base rectangulaire, carrée, hexagonale ou octogonale.

7. Actionneur multicouches selon l'une quelconque des revendications précédentes,
**caractérisé en ce que**
les fils (1 à 11) ou le fil ont un diamètre compris entre 10 $\mu$m jusqu'à 250 $\mu$m notamment 50 $\mu$m jusqu'à 150 $\mu$m.

*Fig. 1*

*Fig. 2*

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19648545 A1
- WO 0079607 A1

- DE 4036287 C2